# EUROPÄISCHE PATENTANMELDUNG

(11) **EP 3 540 539 A1**
(43) Veröffentlichungstag der Anmeldung: **18.09.2019**
(21) Anmeldenummer: 18161933.9
(22) Anmeldetag: 15.03.2018
(51) Int. Cl.: G05B 19/4069, G06F 9/00

(54) **VERFAHREN ZUR RECHNERGESTÜTZTEN SIMULATION DES BETRIEBS EINER AUTOMATISIERT ARBEITENDEN MASCHINE**

(71) Anmelder: Siemens Aktiengesellschaft, 80333 München (DE)
(72) Erfinder: Schlereth, Michael, 91452 Wilhermsdorf (DE)

(57) **Zusammenfassung**

Die Erfindung betrifft ein Verfahren zur rechnergestützten Simulation des Betriebs einer automatisiert arbeitenden Maschine (M), welche im Realbetrieb mittels eines Softwarecodes (COD) auf einer speicherprogrammierbaren Steuerung (CO) steuerbar ist. Erfindungsgemäß wird eine simulierte Steuerung der Maschine (M) mittels des Softwarecodes (COD) auf einem Simulationsrechner (SC) basierend auf einem vorgegebenen Ausführungsmuster (SP) durchgeführt, wobei in dem vorgegebenen Ausführungsmuster (SP) die zeitliche Ausführungsreihenfolge (EO) von durch den Softwarecode (COD) ausgeführten Prozessen (PR) sowie die Anfangszeitpunkte (ST) der Prozesse (PR) basierend auf einer virtuellen Zeit (VT) festgelegt sind und die Ausführungszeit jedes Prozesses (PR) in der virtuellen Zeit auf null gesetzt ist. Im Rahmen der simulierten Steuerung wird erst nach Beendigung eines Prozesses (PR) in der Realzeit (RT) des Simulationsrechners (SC) der nächste Prozess (PR), der auf den beendeten Prozess (PR) gemäß der Ausführungsreihenfolge (EO) folgt, gestartet, wobei die virtuelle Zeit (VT) bei Start des nächsten Prozesses auf den Anfangszeitpunkt (ST) dieses nächsten Prozesses (PR) gesetzt wird.

## Beschreibung

Die Erfindung betrifft ein Verfahren zur rechnergestützten Simulation des Betriebs einer automatisiert arbeitenden Maschine. Ferner betrifft die Erfindung einen Simulationsrechner sowie ein Computerprogrammprodukt und ein Computerprogramm.

In industriellen Automatisierungssystemen werden für den Betrieb von automatisiert arbeitenden Maschinen speicherprogrammierbare Steuerungen genutzt, die auch als PLCs bezeichnet werden (PLC = Programmable Logic Controller). Auf den PLCs ist jeweils ein Softwarecode hinterlegt, der den Betrieb einer entsprechenden Maschine steuert. Dabei werden verschiedene Programmbausteine des Softwarecodes ausgeführt, welche vorgegebene Aufgaben der Maschine durchführen. Die Programmbausteine werden in der Regel zyklisch wiederholt und können verschiedene Funktionen übernehmen. Beispielsweise kann ein Programmbaustein einen Maschinenantrieb steuern und ein anderer Programmbaustein eine Bahnplanung für die Bewegung der Maschine durchführen. Für die Programmbausteine sind in der Regel Prioritäten festgelegt, so dass ein Programmbaustein mit einer höheren Priorität bevorzugt gegenüber Programmbausteinen mit niedrigerer Priorität ausgeführt wird.

Softwarecode für speicherprogrammierbare Steuerungen wird in der Regel weiterentwickelt, um beispielsweise neue Funktionen in dem Softwarecode zu implementieren. Deshalb besteht das Bedürfnis, den Softwarecode vor der eigentlichen Verwendung in der entsprechenden speicherprogrammierbaren Steuerung auf einem Simulationsrechner zu testen, d.h. den Betrieb der mit der speicherprogrammierbaren Steuerung gesteuerten Maschine mit dem entsprechenden Softwarecode zu simulieren. Über eine solche Simulation können vorab Programmierfehler erkannt werden, die zu einem fehlerhaften Verhalten der Maschine im Realbetrieb führen würden.

Bei der Simulation des Betriebs einer Maschine durch einen Simulationsrechner besteht das Problem, dass die Rechengeschwindigkeit des Prozessors des Simulationsrechners in der Regel deutlich von der Rechengeschwindigkeit der CPU einer speicherprogrammierbaren Steuerung abweicht. Dies kann dazu führen, dass die Ausführungsreihenfolge der Programmbausteine auf dem Simulationsrechner von der Ausführungsreihenfolge auf einer realen speicherprogrammierbaren Steuerung abweicht, so dass die Simulation andere Ergebnisse als die reale speicherprogrammierbare Steuerung liefert.

Um dieses Problem zu vermeiden, gibt es aus dem Stand der Technik Ansätze, wonach der Zeitverbrauch jeweiliger Instruktionen des Softwarecodes auf einer realen speicherprogrammierbaren Steuerung abgeschätzt wird und die Ausführungszeit der entsprechenden Instruktionen auf den Simulationsrechner daran angepasst wird. Diese Vorgehensweise ist aufwändig, da eine Vielzahl von Instruktionen im Hinblick auf ihre Zeitdauer analysiert werden müssen. Ferner wird durch diesen Ansatz die Simulationsdauer auf dem Simulationsrechner verlängert.

Aufgabe der Erfindung ist es deshalb, ein Verfahren zur rechnergestützten Simulation eines Betriebs einer automatisiert arbeitenden Maschine zu schaffen, mit dem einfach und schnell der Realbetrieb der Maschine mittels eines Simulationsrechners simuliert werden kann.

Diese Aufgabe wird durch das Verfahren gemäß Patentanspruch 1 bzw. den Simulationsrechner gemäß Patentanspruch 7 gelöst. Weiterbildungen der Erfindung sind in den abhängigen Ansprüchen definiert.

Das erfindungsgemäße Verfahren dient zur rechnergestützten Simulation des Betriebs einer automatisiert arbeitenden Maschine, welche im Realbetrieb mittels eines Softwarecodes auf einer speicherprogrammierbaren Steuerung steuerbar ist. Der Begriff der automatisiert arbeitenden Maschine ist weit zu verstehen. Im Besonderen kann eine solche Maschine auch mehrere Komponenten aufweisen und in diesem Sinne eine technische Anlage darstellen. Die Maschine kann dabei zur automatisierten Durchführung beliebiger Prozesse vorgesehen sein. Insbesondere kann es sich bei der Maschine um eine Werkzeugmaschine handeln. Unter einer Werkzeugmaschine ist eine Maschine zu verstehen, welche ein Werkstück spanend bearbeitet, wie z.B. eine Drehmaschine oder eine Fräsmaschine. Ebenso kann es sich bei der automatisiert arbeitenden Maschine um eine Produktionsmaschine handeln, wie z.B. um eine Verpackungsmaschine. Darüber hinaus kann die Maschine auch eine Logistikanlage oder ein Teil einer Logistikanlage sein, wie z.B. ein automatisiert bedientes Hochregal.

Im Rahmen des erfindungsgemäßen Verfahrens wird eine simulierte Steuerung der Maschine mittels des Softwarecodes auf einem Simulationsrechner durchgeführt. Mit anderen Worten wird der Softwarecode im Rahmen der Simulation nicht auf einer speicherprogrammierbaren Steuerung, sondern auf einem Simulationsrechner, d.h. einer entsprechenden CPU dieses Rechners, zur Ausführung gebracht. Die simulierte Steuerung basiert dabei auf einem vorgegebenen Ausführungsmuster. In dem vorgegebenen Ausführungsmuster wird die zeitliche Ausführungsreihenfolge von durch den Softwarecode ausgeführten Prozessen basierend auf einer virtuellen Zeit festgelegt. Ebenso werden die Anfangszeitpunkte dieser Prozesse basierend auf der virtuellen Zeit spezifiziert. Darüber hinaus ist die Ausführungszeit jedes Prozesses in der virtuellen Zeit auf null gesetzt. Es wird somit in einer virtuellen Zeit, welche der Zeit im simulierten Realbetrieb entspricht, ein dem Realbetrieb entsprechendes Ausführungsmuster vorgegeben.

Durch das Setzen der Ausführungszeit der jeweiligen Prozesse auf null wird erreicht, dass das Ausführungsmuster deterministisch und nicht basierend auf Prioritäten von Prozessen ausgeführt wird, denn jeder Prozess ist in der virtuellen Zeit instantan nach seinem Start zu Ende, so dass es nicht zu Prozessunterbrechungen aufgrund von anderen Prozessen mit höheren Prioritäten kommen kann.

Erfindungsgemäß wird im Rahmen der simulierten Steuerung der Maschine erst nach Beendigung eines Prozesses in der Realzeit des Simulationsrechners der nächste Prozess, der auf den beendeten Prozess gemäß der Ausführungsreihenfolge folgt, gestartet, wobei die virtuelle Zeit bei Start des nächsten Prozesses auf den Anfangszeitpunkt dieses nächsten Prozesses gesetzt wird. Mit diesem Merkmal wird sichergestellt, dass die tatsächliche Prozessausführung gemäß der Realzeit des Simulationsrechners der simulierten Prozessausführung folgt und die virtuelle Zeit entsprechend nachgeregelt wird, obwohl die Ausführungszeiten der jeweiligen Prozesse in der virtuellen Zeit auf null gesetzt sind. Als Ergebnis der Simulation erhält man Ausgaben, die im Rahmen der Simulation durch die Ausführung des Softwarecodes erzeugt wurden. Entsprechende Eingaben, welche durch den Betrieb der realen Maschine hervorgerufen sind (z.B. Maschinenpositionen), werden dabei simuliert. Die durch die Simulation erhaltenen Ausgaben können anschließend ausgewertet werden, um zu bestimmen, ob der simulierte Betrieb der Maschine einem gewünschten Verhalten entspricht.

Das erfindungsgemäße Verfahren weist den Vorteil auf, dass auf einfache Weise ein bestimmtes Ausführungsmuster von Prozessen in einem Simulationsrechner abgebildet werden kann. Dies wird durch die Festsetzung der Ausführungszeiten der Prozesse auf null in einer virtuellen Zeit erreicht sowie durch die Nachstellung der virtuellen Zeit bei der Beendigung eines entsprechenden Prozesses auf dem Simulationsrechner. Die Simulation kann dabei mit der vollen Geschwindigkeit des Simulationsrechners durchgeführt werden. Darüber hinaus ist es nicht erforderlich, die Ausführungszeiten entsprechender Instruktionen auf der speicherprogrammierbaren Steuerung abzuschätzen, wie dies im Stand der Technik der Fall ist.

In einer bevorzugten Variante des erfindungsgemäßen Verfahrens basiert das vorgegebene Ausführungsmuster auf einer realen Prozessausführung, gemäß der Prozesse von einer realen automatisiert arbeitenden Maschine mittels eines Softwarecodes auf einer realen speicherprogrammierbaren Steuerung ausgeführt wurden, wobei die zeitliche Ausführungsreihenfolge der Prozesse und deren Anfangszeitpunkte in der realen Prozessausführung der Ausführungsreihenfolge und den Anfangszeitpunkten der Prozesse in dem vorgegebenen Ausführungsmuster entsprechen. Mit anderen Worten unterscheidet sich das vorgegebene Ausführungsmuster gegenüber der realen Prozessausführung dahingehend, dass die Ausführungszeiten der einzelnen Prozesse auf null gesetzt sind, was in der realen Prozessausführung nicht der Fall ist.

In einer Variante der soeben beschriebenen Ausführungsform wird das vorgegebene Ausführungsmuster aus einer digitalen Spezifikation der realen Prozessausführung im Rahmen des erfindungsgemäßen Verfahrens berechnet. Ebenso ist es möglich, dass ein vorgegebenes Ausführungsmuster basierend auf der realen Prozessausführung bereits zu Beginn des erfindungsgemäßen Verfahrens in digitaler Form vorliegt und im Rahmen des Verfahrens eingelesen wird.

Der Softwarecode, der bei der realen Prozessausführung verwendet wurde, entspricht in einer Variante der Erfindung dem auf dem Simulationsrechner laufenden Softwarecode. Nichtsdestotrotz kann der Softwarecode auf dem Simulationsrechner auch Unterschiede zum Softwarecode der realen Prozessausführung aufweisen. Zum Beispiel kann der Softwarecode auf dem Simulationsrechner eine Weiterentwicklung des Softwarecodes der realen Prozessausführung sein, wobei es das Ziel des erfindungsgemäßen Verfahrens ist, den weiterentwickelten Softwarecode im Rahmen einer Simulation zu testen. Solche Tests werden üblicherweise als Regressionstests bezeichnet.

In einer weiteren Variante des erfindungsgemäßen Verfahrens wird in dem vorgegebenen Ausführungsmuster eine durch einen Programmbaustein des Softwarecodes ausgeführte Aufgabe, welche ein oder mehrere Male durch einen anderen Programmbaustein unterbrochen wird, derart dargestellt, dass die benachbart zu den Unterbrechungen liegenden Ausführungsabschnitte der Aufgabe durch separate Prozesse mit der Anfangszeit des Beginns des Ausführungsabschnitts und einer Ausführungszeit von null repräsentiert werden. Auf diese Weise kann auch die Priorisierung von Aufgaben im Rahmen des erfindungsgemäßen Verfahrens deterministisch simuliert werden.

Je nach Verwendungszweck des erfindungsgemäßen Verfahrens kann das vorgegebene Ausführungsmuster einen vorgegebenen Fehlerfall im Betrieb einer automatisiert arbeitenden Maschine und/oder eine Steuerung einer automatisiert arbeitenden Maschine über eine speicherprogrammierbare Steuerung mit einer vorgegebenen Rechenleistung repräsentieren. Auf diese Weise können verschiedene Fehlerszenarien bzw. verschiedene Arten von speicherprogrammierbaren Steuerungen bei der Simulation berücksichtigt werden.

In einer weiteren Ausgestaltung wird in dem erfindungsgemäßen Verfahren vor der Ausführung der Prozesse auf dem Simulationsrechner gemäß dem vorgegebenen Ausführungsmuster überprüft, ob das vorgegebene Ausführungsmuster auf einer real arbeitenden Maschine überhaupt ausführbar ist, wobei ein Fehlerzustand generiert wird, wenn das vorgegebene Ausführungsmuster auf einer real arbeitenden Maschine nicht ausführbar ist. Je nach Ausgestaltung kann der generierte Fehlerzustand unterschiedliche Folgen haben. Gegebenenfalls kann lediglich ein entsprechender Fehler digital gespeichert werden, der später im Rahmen der Überprüfung der Simulation ausgelesen wird. Ebenso ist es möglich, dass bei der Generierung eines Fehlerzustands eine Warnmeldung über eine Benutzerschnittstelle ausgegeben wird. Hierdurch wird ein Benutzer darauf hingewiesen, dass die Simulation gemäß dem vorgegebenen Ausführungsmuster überhaupt nicht in der Realität umsetzbar ist. Entsprechende Überprüfungen, ob das vorgegebene Ausführungsmuster überhaupt ausführbar ist, liegen im Rahmen von fachmännischem Handeln. Beispielsweise ist das vorgegebene Ausführungsmuster dann nicht ausführbar, wenn hierdurch eine bestimmte Prioritätsreihenfolge der ausgeführten Programmbausteine nicht eingehalten wird.

Neben dem oben beschriebenen Verfahren betrifft die Erfindung einen Simulationsrechner zur rechnergestützten Simulation des Betriebs einer automatisiert arbeitenden Maschine, welche im Realbetrieb mittels eines Softwarecodes auf einer speicherprogrammierbaren Steuerung steuerbar ist, wobei der Simulationsrechner zur Durchführung des erfindungsgemäßen Verfahrens bzw. einer oder mehrerer bevorzugter Varianten des erfindungsgemäßen Verfahrens eingerichtet ist.

Die Erfindung betrifft darüber hinaus ein Computerprogrammprodukt mit einem auf einem maschinenlesbaren Träger gespeicherten Programmcode zur Durchführung des erfindungsgemäßen Verfahrens bzw. einer oder mehrerer bevorzugter Varianten des erfindungsgemäßen Verfahrens, wenn der Programmcode auf einem Computer, der einem zuvor beschriebenen Simulationsrechner entspricht, ausgeführt wird.

Darüber hinaus umfasst die Erfindung ein Computerprogramm mit einem Programmcode zur Durchführung des erfindungsgemäßen Verfahrens bzw. einer oder mehrerer bevorzugter Varianten des erfindungsgemäßen Verfahrens, wenn der Programmcode auf einem Computer, der einem zuvor beschriebenen Simulationsrechner entspricht, ausgeführt wird.

Ausführungsbeispiele der Erfindung werden nachfolgend anhand der beigefügten Figuren detailliert beschrieben.

Es zeigen:
- Fig. 1: ein Zeitdiagramm, welches die Ausführung von Prozessen in einer realen automatisiert arbeitenden Maschine basierend auf unterschiedlichen speicherprogrammierbaren Steuerungen mit verschiedenen Rechenleistungen gemäß dem gleichen Softwarecode auf den Steuerungen wiedergibt;
- Fig. 2: eine schematische Darstellung, welche die wesentlichen Komponenten eines Simulationsrechners darstellt, der in einer Ausführungsform der Erfindung zur Simulation des Betriebs einer automatisiert arbeitenden Maschine verwendet wird; und
- Fig. 3: ein Zeitdiagramm, welches die Ausführung von Prozessen auf dem Simulationsrechner der Fig. 2 basierend auf einer realen Prozessausführung aus Fig. 1 verdeutlicht.

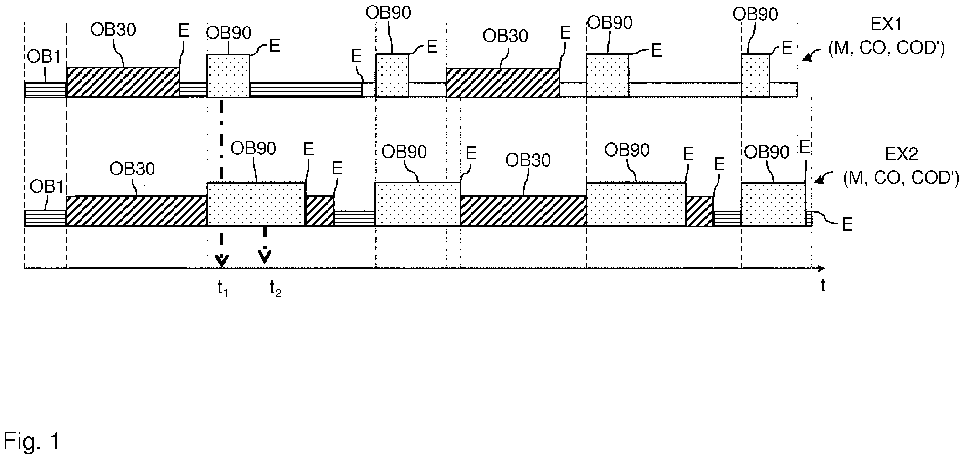

Nachfolgend wird eine Variante des erfindungsgemäßen Verfahrens beschrieben, mit welcher der Betrieb einer automatisiert arbeitenden Maschine, wie z.B. einer Werkzeugmaschine oder einer Produktionsmaschine, für zwei speicherprogrammierbare Steuerungen mit unterschiedlichen Rechenleistungen simuliert wird. Als Grundlage der Simulation werden Ausführungsmuster genutzt, die in der hier beschriebenen Ausführungsform auf den jeweiligen Prozessausführungen EX1 und EX2 der Fig. 1 beruhen, die für eine reale Maschine erfasst wurden.

Die Prozessausführung EX1 betrifft die Durchführung von Prozessen in einer automatisiert arbeitenden Maschine M mit einer speicherprogrammierbaren Steuerung CO mit hoher Prozessorleistung und damit schneller Rechenzeit, wohingegen die Prozessausführung EX2 mit einer speicherprogrammierbaren Steuerung CO mit geringerer Prozessorleistung und damit niedrigerer Rechengeschwindigkeit durchgeführt wurde. Beide speicherprogrammierbaren Steuerungen verwenden den gleichen Softwarecode COD', wobei jedoch aufgrund der unterschiedlichen Rechenleistungen der speicherprogrammierbaren Steuerungen verschiedene Prozessausführungen EX1 und EX2 erhalten werden.

Gemäß dem Diagramm der Fig. 1 ist entlang der Abszisse die reale Zeit der beiden Prozessausführungen EX1 und EX2 angedeutet. Durch die in Fig. 1 wiedergegebenen Balken mit den unterschiedlichen Musterfüllungen wird die Ausführung von Programmbausteinen des Softwarecodes COD' mit jeweiligen speicherprogrammierbaren Steuerungen CO angedeutet. Balken mit der gleichen Musterfüllung betreffen dabei den gleichen Programmbaustein. Für die Bezeichnung der Programmbausteine werden die Bezugszeichen OB1, OB30 und OB90 verwendet. Weiße Balken repräsentieren in Fig. 1 Zeitabschnitte, in denen kein Programmbaustein ausgeführt wird. Durch das Bezugszeichen E werden ferner die Endzeitpunkte der Ausführung der entsprechenden Programmbausteine angedeutet. Mit anderen Worten stellen Übergänge zwischen verschiedenen Balken, welche nicht mit dem Bezugszeichen E versehen sind, nicht das Ende des links vom Übergang liegenden Programmbausteins dar, sondern es wird hierdurch eine Unterbrechung dieses Programmbausteins angedeutet.

Durch die Höhe der Balken wird die Priorität der Programmbausteine bei deren Ausführung repräsentiert. Mit anderen Worten ist die Priorität des entsprechenden Programmbausteins umso höher, je höher der Balken ist. In dem Szenario der Fig. 1 hat somit der Programmbaustein OB1 die niedrigste Priorität, was bedeutet, dass die zur Ausführung anstehenden Programmbausteine OB30 und OB90 einen gerade ausgeführten Programmbaustein OB1 unterbrechen. Demgegenüber hat der Programmbaustein OB30 mittlere Priorität, d.h. dieser Programmbaustein wird nur durch den Programmbaustein OB90 unterbrochen. Der Programmbaustein OB90 hat die höchste Priorität, d.h. eine anstehende Ausführung dieses Programmbausteins führt immer zur Unterbrechung der beiden anderen Programmbausteine OB1 und OB30.

Gemäß der Prozessausführung EX1 der schnelleren speicherprogrammierbaren Steuerung wird der Prozess OB1 einmal durch den Prozess OB30 und ein anderes Mal durch den Prozess OB90 unterbrochen. Demgegenüber wird der Prozess OB30 kein einziges Mal durch den Prozess OB90 unterbrochen. Im Unterschied hierzu wird bei der Prozessausführung EX2 der langsameren speicherprogrammierbaren Steuerung sowohl der linke Programmbaustein OB30 als auch der zeitlich spätere rechte Programmbaustein OB30 einmal durch einen entsprechenden Programmbaustein OB90 unterbrochen. Darüber hinaus existieren eine größere Anzahl an Unterbrechungen des Programmbausteins OB1. Die höhere Anzahl an Unterbrechungen resultiert aus der höheren Rechenzeit bei der Ausführung der einzelnen Programmbausteine, so dass öfter Unterbrechungen durch höher priorisierte Programmbausteine auftreten.

In der hier beschriebenen Ausführungsform des erfindungsgemäßen Verfahrens wird ein Ausführungsmuster zur Simulation des Betriebs der Maschine M sowohl basierend auf der schnellen speicherprogrammierbaren Steuerung entsprechend der Prozessausführung EX1 als auch basierend auf der langsameren speicherprogrammierbaren Steuerung entsprechend der Prozessausführung EX2 verwendet.

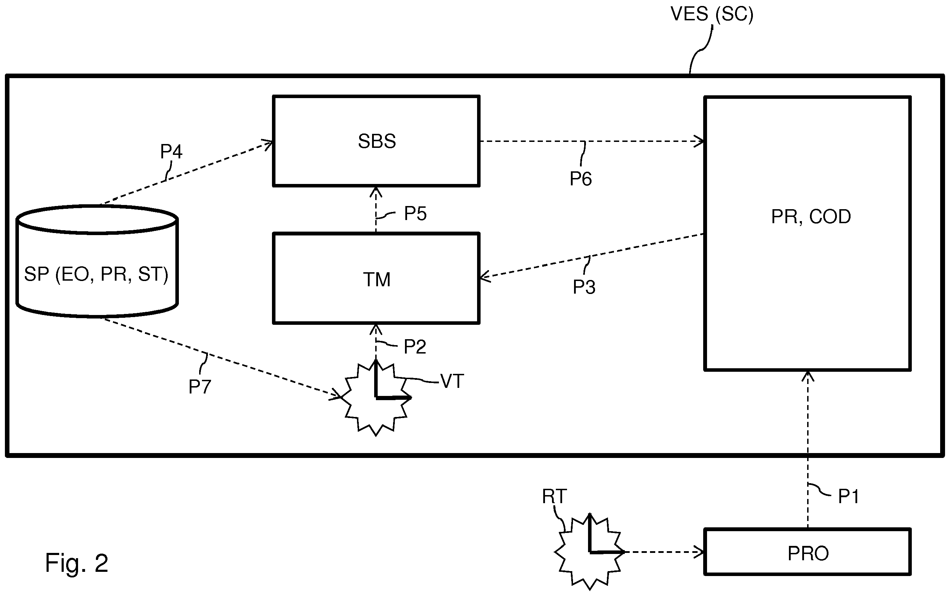

Das Ausführungsmuster, welches in der weiter unten beschriebenen Fig. 2 mit SP (SP = Sequence Pattern) bezeichnet ist, gibt die in den jeweiligen Prozessausführungen EX1 und EX2 dargestellten Programmbausteine in der Form von Prozessen wieder. Ein Prozess entspricht dabei der zusammenhängenden Ausführung des jeweiligen Programmbausteins bis zu seinem Ende bzw. einer Unterbrechung. Mit anderen Worten besteht ein Programmbaustein, der ein oder mehrmals durch andere Programmbausteine unterbrochen wird, aus mehreren Prozessen, welche die jeweiligen Teilabschnitte des Programmbausteins zeitlich benachbart zu den Programmbausteinen darstellen, welche die Unterbrechung verursachen. Sollte ein Programmbaustein nicht unterbrochen werden, entspricht dieser Programmbaustein einem einzelnen Prozess des Ausführungsmusters. In dem Ausführungsmuster sind ferner die Anfangszeitpunkte der jeweiligen Prozesse hinterlegt.

Das Ausführungsmuster kann vorab berechnet worden sein und aus seinem Speicher ausgelesen werden. Ebenso ist es möglich, dass das Ausführungsmuster mit den entsprechenden Prozessen und deren Anfangszeitpunkten im Rahmen des Simulationsverfahrens aus den jeweiligen Prozessausführungen der Fig. 1 berechnet wird.

In Fig. 1 sind ferner durch strichpunktierte Pfeile zwei Zeitpunkte t1 und t2 angedeutet. Der Zeitpunkt t1 repräsentiert den Befehl des Einlesens der aktuellen Zeit durch den Programmbaustein OB90 der Prozessausführung EX1. Dieser Befehl wird auch im entsprechenden Programmbaustein OB90 der Prozessausführung EX2 durchgeführt, jedoch zu dem späteren Zeitpunkt t2, der aus der langsameren Prozessausführung resultiert. Das hier beschriebene Verfahren beruht auf der Annahme, dass der Unterschied zwischen solchen Zeiten innerhalb eines jeweiligen Programmbausteins keine Relevanz auf die weitere Prozessausführung hat, so dass für diese Zeiten auch der Anfangszeitpunkt des entsprechenden Programmbausteins verwendet werden kann.

Fig. 2 verdeutlicht ein virtuelles Ausführungssystem VES (VES = Virtual Execution System) für eine speicherprogrammierbare Steuerung, das Bestandteil eines Simulationsrechners SC ist. Neben dem Ausführungssystem enthält der Simulationsrechner eine CPU bzw. einen Prozessor, der in Fig. 2 mit PRO bezeichnet ist. Mittels des Prozessors wird ein Softwarecode COD ausgeführt. Dieser Softwarecode stellt eine Weiterentwicklung des entsprechenden Softwarecodes COD' aus Fig. 1 dar. Es soll nunmehr im Rahmen eines Regressionstests durch Simulation ermittelt werden, ob der weiterentwickelte Softwarecode COD zu einem Fehler im Maschinenbetrieb bei dessen Verwendung in einer realen speicherprogrammierbaren Steuerung führen würde. Hierzu wird der Softwarecode COD auf dem Rechner SC durch den Prozessor PRO ausgeführt, was durch den Pfeil P1 sowie das rechte Rechteck innerhalb des virtuellen Ausführungssystems VES angedeutet ist. Der Prozessor PRO arbeitet dabei mit der Realzeit RT.

Zum Test des Softwarecodes COD wird das Ausführungsmuster SP verwendet, wobei dieses Muster je nach ausgeführtem Test auf der Prozessausführung EX1 für die schnellere speicherprogrammierbare Steuerung oder auf der Prozessausführung EX2 für die langsamere speicherprogrammierbare Steuerung beruht. Das Ausführungsmuster SP enthält die Ausführungsreihenfolge der oben beschriebenen Prozesse entsprechend der Prozessausführung EX1 bzw. EX2. Diese Ausführungsreihenfolge ist in Fig. 2 mit EO (EO = Execution Order) bezeichnet, wohingegen die Prozesse sind mit PR bezeichnet sind. Ferner sind die entsprechenden Startzeitpunkte der jeweiligen Prozesse PR mit ST bezeichnet.

Das virtuelle Ausführungssystem VES verwendet für das Ausführungsmuster SP eine virtuelle Zeit VT, durch welche die Zeit der Prozessausführung auf der jeweiligen speicherprogrammierbaren Steuerung repräsentiert wird. Mit anderen Worten sind die Startzeitpunkte ST in dem Ausführungsmuster SP in der virtuellen Zeit VT angegeben. Ein erfindungswesentlicher Aspekt besteht nunmehr darin, dass die Ausführungsdauer für einen jeweiligen Prozess PR auf null gesetzt wird. Auf diese Weise wird sichergestellt, dass die Ausführungsreihenfolge EO eingehalten wird und es nicht zu Unterbrechungen bei der Ausführung von Prozessen kommt, denn die jeweilige Ausführung eines Prozesses ist instantan beendet.

Das virtuelle Ausführungssystem VES beinhaltet ferner eine Zeitverwaltungseinheit TM, die auf der virtuellen Zeit VT basiert, wie durch den Pfeil P2 angedeutet ist. Mit dieser Zeitverwaltungseinheit werden u.a. zu bestimmten Zeitpunkten gemäß Instruktionen aus dem Softwarecode COD Zeitlesebefehle ausgeführt, was durch den Pfeil P3 angedeutet ist. Da die entsprechende Ausführungszeit der Prozesse null ist, werden auf diese Weise die in Fig. 1 angedeuteten Zeitpunkte t1 und t2 auf die entsprechende virtuelle Anfangszeit des Programmbausteins OB90 abgebildet.

Das virtuelle Ausführungssystem VES der Fig. 2 beinhaltet ferner einen deterministischen Zeitplaner, der mit Bezugszeichen SBS (SBS = Sequence based Scheduler) bezeichnet ist. Dieser Planer verarbeitet das Ausführungsmuster SP, wie durch den Pfeil P4 angedeutet ist. Der Zeitplaner wird basierend auf der virtuellen Zeit VT mittels der Zeitverwaltungseinheit TM ausgelöst, wie durch den Pfeil P5 angedeutet ist. Der Zeitplaner SBS startet die Prozesse gemäß den Programmbausteinen des Softwarecodes COD, wie durch den Pfeil P6 angedeutet ist.

Um sicherzustellen, dass nach Ausführung der jeweiligen Prozesse die virtuelle Zeit VT nachgeführt wird, wird diese Zeit basierend auf dem Ausführungsmuster SP nachgestellt, was durch den Pfeil P7 angedeutet ist. Diese Nachstellung läuft derart ab, dass erst nach der Beendigung eines entsprechenden Prozesses in der Realzeit RT des Prozessors PRO die virtuelle Zeit VT neu gesetzt wird, und zwar auf den Anfangszeitpunkt des nächsten Prozesses des Ausführungsmusters SP.

Wie sich aus der obigen Beschreibung ergibt, wird durch das System der Fig. 2 auf einfache Weise eine deterministische Prozessausführung zur simulierten Steuerung einer Maschine basierend auf einer schnellen und einer langsamen speicherprogrammierbaren Steuerung erreicht. Erfindungswesentlich ist dabei, dass in einer virtuellen Zeit die Ausführungszeit der Prozesse auf null gesetzt wird, um hierdurch die Ausführungsreihenfolge einzuhalten, und dass ferner die virtuelle Zeit auf den Anfangszeitpunkt eines nachfolgenden Prozesses gesetzt wird, wenn der vorhergehende Prozess gemäß der Realzeit des Simulationsrechners abgeschlossen ist.

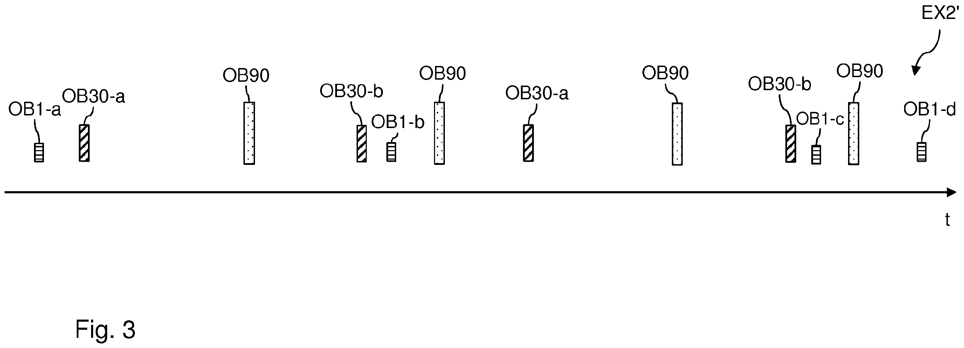

Fig. 3 verdeutlicht beispielhaft nochmals eine Prozessausführung EX2' gemäß dem Ausführungsmuster SP der Fig. 2, und zwar basierend auf der Prozessausführung EX2 einer langsamen speicherprogrammierbaren Steuerung. Die Abszisse repräsentiert dabei die virtuelle Zeit. Wie sich aus Fig. 3 ergibt, existiert für jeden zusammenhängenden Abschnitt der Balken aus der Prozessausführung EX2 der Fig. 1 ein entsprechender Prozess in Fig. 3, wobei die Prozesse in Fig. 3 als schmale Balken wiedergegeben sind. Wurde der Prozess in Fig. 1 nicht unterbrochen, entspricht der Balken in Fig. 3 einem Programmbaustein. Dies ist für die Programmbausteine OB90 der Fall.

Demgegenüber existieren für aus Unterbrechungen resultierende Teilabschnitte von Programmbausteinen aus Fig. 1 entsprechende separate Prozesse in der Prozessausführung EX2' der Fig. 3. Für den Programmbaustein OB1 existieren somit aufgrund dessen Unterbrechungen vier Prozesse OB1-a, OB1-b, OB1-c und OB1-d. Ferner wurde auch der linke Programmbaustein OB30 der Fig. 1 durch den Programmbaustein OB90 unterbrochen, woraus zwei Prozesse OB30-a und OB30-b resultieren. Entsprechend gibt es aufgrund der Unterbrechung des rechten Programmbausteins OB30 auch zwei Prozesse OB30-a und OB30-b.

Durch die Wiedergabe von schmalen Balken wird in Fig. 3 angedeutet, dass die Programmbausteine bzw. deren Teilabschnitte in dem Ausführungsmuster SP eine Ausführungszeit von Null haben. Die Positionen der Balken in Fig. 3 entsprechen somit den Anfangszeitpunkten der jeweiligen Prozesse.

Die im Vorangegangenen beschriebene Ausführungsform der Erfindung weist eine Reihe von Vorteilen auf. Durch die Verwendung einer virtuellen Zeit im Rahmen der Simulation eines Maschinenbetriebs kann eine Ausführungszeit von Null für entsprechende Prozesse festgelegt werden. Auf diese Weise kann ein deterministischer Zeitablauf der Prozessausführung erreicht werden. Darüber hinaus können Codeunterbrechungen durch die Definition von separaten Prozessen für entsprechende Teilabschnitte von Programmbausteinen abgebildet werden und hierdurch ein prioritätsbasiertes Verhalten simuliert werden. Der Prozessor des Simulationsrechners kann dabei mit voller Geschwindigkeit arbeiten und wird nicht durch die virtuelle Zeit verzögert. Durch die Verwendung eines vordefinierten Ablaufverhaltens basierend auf einem entsprechenden Ausführungsmuster können speicherprogrammierbare Steuerungen mit verschiedenen Leistungsklassen im Rahmen der Simulation berücksichtigt werden.

## Patentansprüche

1. Verfahren zur rechnergestützten Simulation des Betriebs einer automatisiert arbeitenden Maschine (M), welche im Realbetrieb mittels eines Softwarecodes (COD) auf einer speicherprogrammierbaren Steuerung (CO) steuerbar ist, wobei
- eine simulierte Steuerung der Maschine (M) mittels des Softwarecodes (COD) auf einem Simulationsrechner (SC) basierend auf einem vorgegebenen Ausführungsmuster (SP) durchgeführt wird, wobei in dem vorgegebenen Ausführungsmuster (SP) die zeitliche Ausführungsreihenfolge (EO) von durch den Softwarecode (COD) ausgeführten Prozessen (PR) sowie die Anfangszeitpunkte (ST) der Prozesse (PR) basierend auf einer virtuellen Zeit (VT) festgelegt sind und die Ausführungszeit jedes Prozesses (PR) in der virtuellen Zeit (VT) auf null gesetzt ist;
- wobei im Rahmen der simulierten Steuerung erst nach Beendigung eines Prozesses (PR) in der Realzeit (RT) des Simulationsrechners (SC) der nächste Prozess (PR), der auf den beendeten Prozess (PR) gemäß der Ausführungsreihenfolge (EO) folgt, gestartet wird, wobei die virtuelle Zeit (VT) bei Start des nächsten Prozesses (PR) auf den Anfangszeitpunkt (ST) dieses nächsten Prozesses (PR) gesetzt wird.

2. Verfahren nach Anspruch 1, wobei das vorgegebene Ausführungsmuster (SP) auf einer realen Prozessausführung (EX1, EX2) basiert, gemäß der Prozesse von einer realen automatisiert arbeitenden Maschine (M) mittels eines Softwarecodes (COD') auf einer realen speicherprogrammierbaren Steuerung (CO) ausgeführt wurden, wobei die zeitliche Ausführungsreihenfolge der Prozesse und deren Anfangszeitpunkte in der realen Prozessausführung (EX1, EX2) der Ausführungsreihenfolge (EO) und den Anfangszeitpunkten (ST) der Prozesse (PR) in dem vorgegebenen Ausführungsmuster (SP) entsprechen.

3. Verfahren nach Anspruch 1 oder 2, wobei in dem vorgegebenen Ausführungsmuster (SP) eine durch einen Programmbaustein (OB1, OB30, OB90) des Softwarecodes (COD) ausgeführte Aufgabe, welche ein oder mehrere Male durch einen anderen Programmbaustein (OB1, OB30, OB90) unterbrochen wird, derart dargestellt wird, dass die benachbart zu den Unterbrechungen liegenden Ausführungsabschnitte der Aufgabe durch separate Prozesse (PR) mit dem Anfangszeitpunkt (SP) des Beginns des Ausführungsabschnitts und einer Ausführungszeit von Null repräsentiert werden.

4. Verfahren nach einem der vorhergehenden Ansprüche, wobei das vorgegebene Ausführungsmuster (SP) einen vorgegebenen Fehlerfall im Betrieb der automatisiert arbeitenden Maschine (M) und/oder eine Steuerung der automatisiert arbeitenden Maschine (M) über eine speicherprogrammierbare Steuerung (CO) mit einer vorgegebenen Rechenleistung repräsentiert.

5. Verfahren nach einem der vorhergehenden Ansprüche, wobei in dem Verfahren vor der Ausführung der Prozesse (PR) auf dem Simulationsrechner (SC) gemäß dem vorgegebenen Ausführungsmuster (SP) überprüft wird, ob das vorgegebene Ausführungsmuster (SP) auf einer real arbeitenden Maschine (M) überhaupt ausführbar ist, und ein Fehlerzustand generiert wird, wenn das vorgegebene Ausführungsmuster (SP) auf einer real arbeitenden Maschine (M) nicht ausführbar ist.

6. Verfahren nach einem der vorhergehenden Ansprüche, wobei der Betrieb einer automatisiert arbeitenden Maschine (M) in der Form einer Werkzeugmaschine oder einer Produktionsmaschine oder zumindest eines Teils einer Logistikanlage simuliert wird.

7. Simulationsrechner zur rechnergestützten Simulation des Betriebs einer automatisiert arbeitenden Maschine (M), welche im Realbetrieb mittels eines Softwarecodes (COD) auf einer speicherprogrammierbaren Steuerung (CO) steuerbar ist, wobei der Simulationsrechner (SC) zur Durchführung eines Verfahrens eingerichtet ist, bei dem
- eine simulierte Steuerung der Maschine (M) mittels des Softwarecodes (COD) auf dem Simulationsrechner (SC) basierend auf einem vorgegebenen Ausführungsmuster (SP) von Prozessen (PR) durchgeführt wird, wobei in dem vorgegebenen Ausführungsmuster (SP) die zeitliche Ausführungsreihenfolge (EO) von durch den Softwarecode (COD) ausgeführten Prozessen (PR) sowie die Anfangszeitpunkte (ST) der Prozesse (PR) basierend auf einer virtuellen Zeit (VT) festgelegt sind und die Ausführungszeit jedes Prozesses (PR) in der virtuellen Zeit (VT) auf null gesetzt ist;
- wobei im Rahmen der simulierten Steuerung erst nach Beendigung eines Prozesses (PR) in der Realzeit (RT) des Simulationsrechners (SC) der nächste Prozess (PR), der auf den beendeten Prozess (PR) gemäß der Ausführungsreihenfolge (EO) folgt, gestartet wird, wobei die virtuelle Zeit (VT) bei Start des nächsten Prozesses (PR) auf den Anfangszeitpunkt (ST) dieses nächsten Prozesses (PR) gesetzt wird.

8. Simulationsrechner nach Anspruch 7, wobei der Simulationsrechner (SC) zur Durchführung eines Verfahrens nach einem der Ansprüche 2 bis 6 eingerichtet ist.

9. Computerprogrammprodukt mit einem auf einem maschinenlesbaren Träger gespeicherten Programmcode zur Durchführung eines Verfahrens nach einem der Ansprüche 1 bis 6, wenn der Programmcode auf einem Computer, der einem Simulationsrechner (SC) entspricht, ausgeführt wird.

10. Computerprogramm mit einem Programmcode zur Durchführung eines Verfahrens nach einem der Ansprüche 1 bis 6, wenn der Programmcode auf einem Computer, der einem Simulationsrechner (SR) entspricht, ausgeführt wird.
